# EUROPÄISCHE PATENTANMELDUNG

(11) **EP 1 239 712 A2**
(43) Veröffentlichungstag der Anmeldung: **11.09.2002**
(21) Anmeldenummer: 01250437.9
(22) Anmeldetag: 12.12.2001
(51) Int. Cl.: H05K 7/02

(54) **Elektronische Schaltung zur Datenfernübertragung**

(30) Priorität: 08.03.2001 DE 10112324
(71) Anmelder: Insys Microelectronics GmbH, 93047 Regensburg (DE); Stollmann Entwicklungs- und Vertriebs GmbH, 22761 Hamburg (DE)
(72) Erfinder: Wagner, Eduard B., 93051 Regensburg (DE); Lührs, Christian, 22041 Hamburg (DE)
(74) Vertreter: Jungblut, Bernhard Jakob, Dr.

(57) **Zusammenfassung**

Die Erfindung betrifft eine elektronische Schaltung zur Datenfernübertragung mit einer Basisplatine (1), welche eine interne Schnittstelle (2) für ein Datensystem aufweist und mit einer Modulplatine (3), welche zur Umsetzung eines über die interne Schnittstelle (2) für das Datensystem eingespeisten Datenstroms in eine Signalfolge für die Telekommunikationsübertragung eingerichtet ist, wobei die Basisplatine (1) oder die Modulplatine (3) eine interne Schnittstelle (4) für eine Telekommunikationsübertragung aufweist, wobei die Basisplatine (1) zumindest eine Basiskontaktleiste (5) sowie ein Einsteckfeld (6) aufweist, wobei die Modulplatine (3) zumindest eine zur Basiskontaktleiste (5) komplementäre Modulkontaktleiste (7) aufweist, wobei zueinander komplementäre Kontakte der Basiskontaktleiste (5) und der Modulkontaktleiste (7) lösbare elektrische Kontaktpaare sind und die interne Schnittstelle (2) bilden, und wobei die Anordnung der Basiskontaktleiste (5) und der Modulkontaktleiste (7) mit der Maßgabe getroffen ist, daß eine Kontaktierung durch Einsetzen der Modulplatine (3) in dem Einsteckfeld (6) erfolgt.

## Beschreibung

### Gebiet der Erfindung.

Die Erfindung betrifft eine elektronische Schaltung zur Datenfernübertragung, welche eine Schnittstelle für ein Datensystem sowie eine Schnittstelle für eine Telekommunikationsübertragung aufweist. Telekommunikationsübertragung im Sinne der Erfindung umfaßt auch die Datenübertragung und Telekommunikationsnetze können insofern auch Datennetze sein.

### Hintergrund der Erfindung und Stand der Technik.

Im Bereich der Datenfernübertragung ist es erforderlich, Datenströme in den in der Computertechnologie üblichen Protokollen bzw. Schnittstellen so aufzubereiten und zu transformieren, daß die in den Datenströmen enthaltene Information mittels Signalen der Telekommunikationsnetze übertragen werden können. Gebräuchliche Signalprotokolle und Strukturen der Telekommunikationsnetze sind beispielsweise das klassische Analogprotokoll, ISDN und GSM. Hierbei handelt es sich um kontinuierliche Datenübertragung. Daneben gewinnt die Datenübertragung mittels TCP/IP über Internet zunehmend Bedeutung, welche mit Datenpacketen arbeitet.

Einem Nutzer, welcher Datenströme aus einem Datenverarbeitungsgerät übertragen möchte, stehen somit eine Mehrzahl von Telekommunikationsnetze, einschließlich Internet, zur Datenfernübertragung zur Verfügung, aus welchen er auswählen kann.

Aus der Praxis sind sogenannte Modem Karten für Computer bekannt, welche alle Bauelemente für die Umsetzung der Datenströme aus einer computerinternen Schnittstelle in Signale für das ausgewählte Netz umsetzen. Ein Nutzer muß also zunächst das gewünschte Netz wählen, eine für den gewünschten Übertragungsweg geeignete Karte auswählen und erwerben und diese dann in den Computer einbauen. Entsprechende Geräte zum externen Anschluß, beispielsweise an eine genormte parallele oder serielle Schnittstelle eines Computers sind ebenfalls bekannt. Bei diesen Lösungen ist nachteilig, daß ein Nutzer entweder an einen bestimmten Übertragungsweg bzw. ein bestimmtes Telekommunikationsnetz gebunden ist, oder eine Mehrzahl solcher Karten oder externer Geräte erwerben und anschließen muß. Dies ist aufwendig und teuer.

Technisches Problem der Erfindung.

Der Erfindung liegt daher das technische Problem zugrunde, eine elektronische Schaltung zur Datenfernübertragung anzugeben, mittels welcher auf einfache Weise zwischen verschiedenen Übertragungswegen bzw. Telekommunikationsnetzen gewählt werden kann.

Grundzüge der Erfindung und bevorzugte Ausführungsformen.

Zur Lösung dieses technischen Problems lehrt die Erfindung eine elektronische Schaltung zur Datenfernübertragung mit einer Basisplatine, welche eine internen Schnittstelle für ein Datensystem aufweist und mit einer Modulplatine, welche zur Umsetzung eines über die interne Schnittstelle für das Datensystem eingespeisten Datenstroms in eine Signalfolge für die Telekommunikationsübertragung eingerichtet ist, wobei die Basisplatine und/oder die Modulplatine eine interne Schnittstelle für eine Telekommunikationsübertragung aufweist, wobei die Basisplatine zumindest eine Basiskontaktleiste sowie ein Einsteckfeld aufweist, wobei die Modulplatine zumindest eine zur Basiskontaktleiste komplementäre Modulkontaktleiste aufweist, wobei zueinander komplementäre Kontakte der Basiskontaktleiste und der Modulkontaktleiste lösbare elektrische Kontaktpaare sind und die interne Schnittstelle bilden, und wobei die Anordnung der Basiskontaktleiste und der Modulkontaktleiste mit der Maßgabe getroffen ist, daß eine Kontaktierung durch Einsetzen der Modulplatine in dem Einsteckfeld erfolgt.

Die Basisplatine umfaßt typischerweise weiterhin zwei externe Schnittstellen, eine zum Anschluß an einen Computer oder ein sonstiges digitales Datenerfassungssystem und eine zur Verbindung mit einem Telekommunikationsnetz. Bei den folgend behandelten Schnittstellen handelt es sich stets um die internen Schnittstellen zwischen der Basisplatine und einer Modulplatine, sofern nicht anders angegeben.

Die Schnittstelle für ein Datensystem wird typischerweise, aber nicht zwingend, eine hinsichtlich der elektrischen Spezifikationen genormte Schnittstelle sein. Beispielsweise kommt eine RS232 Schnittstelle in Frage. Es kann aber auch eine Schnittstelle einer Basisplatineninternen BUS-Norm sein. Die Schnittstelle wird durch eine Paarung Basiskontaktleiste/Modulkontaktleiste gebildet.

Die externe Schnittstelle für eine Telekommunikationsübertragung kann ein Anschluß für ein draht- oder glasfasergebundenes Telekommunikatiosnetz sein, sie kann aber auch durch eine Antenne für ein Funk-Telekommunikatiosnnetz sein. In beiden Fällen kann die externe Schnittstelle identisch mit der entsprechenden internen Schnittstelle sein. Wenn diese Schnittstelle allein eine interne Schnittstelle ist, so ist sie ebenfalls durch eine Paarung Basiskontaktleiste/Modulkontaktleiste gebildet. Für verschiedene interne Schnittstellen können verschiedene solcher Paarungen vorgesehen sein, sie können aber auch im Rahmen einer einzigen solchen Paarung ausgebildet sein.

Ein Einsteckfeld ist ein definierter Bereich auf der Basisplatine, über welchem die Modulplatine im Zuge des Einsetzens auf die Basisplatine angeordnet wird.

Die Basiskontaktleiste und die Modulkontaktleiste sind sowohl in mechanischer Hinsicht als auch in der Belegung der Kontakte der Kontaktleisten mit Energierversorgungsleitungen und Signalleitungen zueinander komplementär. Ein wesentliches Element der Erfindung ist, daß die verbindung zwischen der Basiskontaktleiste und der Modulkontaktleiste lösbar ist, i.e. die Modulplatine läßt sich von der Basisplatine auch wieder entfernen.

Die Erfindung beruht zunächst auf der Erkenntnis, daß eine beachtliche Anzahl von Bauelementen und Funktionen bei unterschiedlichen konventionellen Schaltungen zur Datenfernübertragung für verschiedene Netze gleich ist. Hieran anschließend wurde erkannt, daß eine wesentliche Vereinfachung erreicht werden kann, wenn die vorstehend angesprochenen Gleichteile auf einer Basisplatine angeordnet werden und nur die für ein bestimmtes Telekommunikationsnetz erforderlichen Bauteile auf einer in die Basisplatine einsetzbaren Modulplatine angeordnet werden. Für den Nutzer ergibt sich schließlich durch den reversiblen Einsatz einer Modulplatine die Möglichkeit, mit vergleichsweise geringem Aufwand eine vorhandene Basisplatine für ein anderes Telekommunikationsnetz umzurüsten, und zwar lediglich durch Austausch der jeweiligen Modulplatinen. Hinzu kommt, daß die Basisplatine selbst für erst zukünftige verfügbare Telekommunikationsnetze weiter verwendet werden kann, nämlich ebenfalls durch Austausch gegen die geeignete Modulplatine, sobald verfügbar. Herstellerseitig ergibt sich der Vorteil, daß sich die Basisplatine in vergleichsweise hohen Stückzahlen preiswert herstellen und nach Nutzerwunsch durch Einsatz der Modulplatine für das gewünschte Telekommunikationsnetz konfigurieren läßt. Bei neuen zukünftigen Telekommunikationsnetzen braucht zudem lediglich eine neue Modulplatine entwickelt zu werden. Mit anderen Worten ausgedrückt, entsteht erst durch die Zusammenfügung der Basisplatine mit zumindest einer Modulplatine eine komplette Schaltung für die Datenfernübertragung.

Im Rahmen der Erfindung wird somit zumindest eine systeminterne Schnittstellennorm geschaffen, und zwar die Schnittstelle für das Datensystem. Zwischen der externen Schnittstelle der Basisplatine für ein Datenverarbeitungsgerät und der internen Schnittstelle für das Datensystem findet eine Aufbereitung des Datenstroms in der Weise statt, daß er mit wenig Aufwand im Rahmen der Schaltung der Modulplatine in eine Signalfolge für die Telekommunikationsübertragung umgewandelt werden kann. Hierbei ist natürlich auch bidirektionaler Datenstrom bzw. Signalfolge möglich. Hieraus folgt, daß an der Schnittstelle für das Datensystem alle Steuer- und Datenleitungen für die einzusetzenden verschiedenen Modulplatinen anliegen müssen. Werden im Rahmen der ausgewählten Modulplatine aufgrund des damit ausgewählten Telekommunikationsübertragungsweges einzelne Steuer- und oder Datenleitungen nicht benötigt, so ist der entsprechende Kontakt der Modulkontaktleiste nicht belegt oder nicht vorhanden. Die systeminterne Schnittstellennorm berücksichtigt also alle einsetzbaren Modulplatinen, wie auch im Rahmen der Ausführungsbeispiele im Einzelnen zu erkennen.

Bevorzugt ist es, wenn die Modulplatine zumindest in den Bereichen zweier einander gegenüberliegenden Kanten jeweils eine Modulkontaktleiste aufweist, wobei die Basisplatine zumindest zwei hierzu komplementär im Bereich des Einsteckfeldes ausgerichtete und angeordnete Basiskontaktleisten aufweist. Hierdurch wird mehrerlei erreicht. Zum Ersten kann auf einen Schutz gegen beispielsweise verdrehten oder verschobenen Einsatz einer Modulkontaktleiste in die Basiskontaktleiste verzichtet werden, da die Orientierung aufgrund der Mehrzahl an jeweiligen Kontaktleisten eindeutig ist. Zum Zweiten wird eine verbesserte mechanische Stabilität, insbesondere auch gegen Vibrationen erreicht, da die Modulplatine sich in verschiedenen Bereichen über die Kontaktleisten auf der Basisplatine abstützt.

Eine Ausführungsform von selbstständiger Bedeutung ist dadurch gekennzeichnet, daß die Modulplatine auf ihrer der die Modulkontaktleiste tragenden Hauptfläche gegenüberliegenden Hauptfläche zumindest eine Aufsatzkontaktleiste zum Einstecken einer weiteren Modulplatine aufweist. Mit anderen Worten ausgedrückt, lassen sich mehrere Modulplatinen gleichsam im Huckepack auf der Basisplatine anbringen. Dies erlaubt es, im Rahmen aller verfügbaren Telekommunikationsnetze wiederum Untergruppen zu bilden, und zwar für solche verschiedene Telekommuniaktionsnetze, die gemeinsame (Teil-) Funktionalitäten benötigen. Es ist aber auch möglich, die Aufsatzkontaktleiste auf der gleichen Hauptfläche der Modulplatine, wie die Modulkontaktleiste anzuordnen. Dann kommt eine "aufgesetzte" Modulplatine zwischen der sie tragenden Modulplatine und der Basisplatine zu liegen.

Eine hierfür beispielhafte Ausführungsform arbeitet mit einer ersten und einer zweiten Modulplatine, welche wahlweise in die Basisplatine einsteckbar sind, wobei die zweite Modulplatine zumindest eine Aufsatzkontaktleiste aufweist, welche in ihrer Ausbildung, Anordnung und Ausrichtung so eingerichtet ist, daß sich die erste Modulplatine auf die in die Basisplatine aufgesteckte zweite Modulplatine aufstecken läßt. So kann beispielsweise die zweite Modulplatine eine TCP/IP Funktionalität aufweisen und die erste Modulplatine ein Modem sein. Dies ermöglich es einem Nutzer, welcher bislang über konventionelle Telekommunikationsnetze mittels der Modem-Funktionalität übertragen hat, auf einfache Weise die Schaltung für Übertragung per Internet umzurüsten. Hierzu muß lediglich die erste Modulplatine (Modem) von der Basisplatine entfernt, die zweite Modulplatine (TCP/IP) stattdessen in die Basisplatine eingesetzt und die erste Modulplatine (Modem) nunmehr auf die zweite Modulplatine (TCP/IP) aufgesetzt werden. Selbstverständlich können auch zunächst die erste und die zweite Modulplatine vor dem Einsetzen in die Basisplatine miteinander verbunden werden.

Vorteilhaft ist hierbei, daß auch im Rahmen der Aufsatzsteckleiste mit der o.g. systeminternen Norm für die Belegung der Kontakte der Kontaktleisten gearbeitet wird.

Die Modulkontaktleiste und die Aufsatzkontaktleiste der zweiten Modulplatine können bezüglich einer senkrecht zu den Hauptflächen der zweiten Modulplatine stehenden Rotationsachse zueinander verdreht, vorzugsweise um 90°, angeordnet sein. Hierdurch wird eine verringerte Bauhöhe bei einer "Stapelung" mehrerer Modulplatinen erreicht und eine Zuführung von Leiterbahnen zu den Kontakten der jeweiligen Kontaktleisten erleichtert.

Bevorzugt ist es, wenn die zweite Modulplatine eine TCP/IP Schaltung trägt und wenn die erste Modulplatine eine Schaltung aus der Gruppe "Modem, ISDN, GSM" trägt.

Die Erfindung lehrt weiterhin einen Modulplatinensatz für eine erfindungsgemäße elektronische Schaltung mit einer Mehrzahl von Modulplatinen mit unterschiedlichen Schaltungen, wobei die Belegung der elektrischen Kontakte der Modulanschlußleisten verschiedener Modulplatinen kompatibel mit der Belegung der elektrischen Kontakte der Basisanschlußleiste(n) ist. Hierbei können im Rahmen einer spezifischen Modulplatine nicht benötigte Daten- oder Steuerleitungen, welche an Kontakten der Basiskontaktleiste anliegen, seitens der Modulkontaktleiste nicht belegt sein. Bezüglich des Modulplatinensatzes geltend die vorstehend getroffenen Ausführungen zu Modulplatinen mit Aufsatzkontaktleisten entsprechend.

Schließlich lehrt die Erfindung eine Modulplatine für eine erfindungsgemäße elektronische Schaltung mit zumindest einer Modulkontaktleiste und zumindest einer Aufsatzkontaktleiste, wobei die Aufsatzkontaktleiste in ihrer Ausbildung und zumindest teilweisen Belegung der elektrischen Kontakte gleich der Basiskontaktleiste ausgebildet ist, wobei vorzugsweise die Aufsatzkontaktleiste und die Modulkontaktleiste bezüglich einer senkrecht zu den Hauptflächen der Modulplatine stehenden Rotationsachse zueinander verdreht, vorzugsweise um 90°, angeordnet sind.

Als Funktionalitäten für die Modulplatinen kommen jeweils beispielsweise in Frage: Modem, ISDN, GSM/GPRS, USB, Ethernet, Bluetooth, 868 MHz Funk, TCP/IP. Es ist schließlich auch möglich, eine Modulplatine ohne Funktionalität vorzusehen, auf welcher ein Anwender eine eigene Funktionalität einrichten kann (Leerplatine). Ein Anwender muß dabei lediglich die Norm der (internen) Schnittstellen bei der Belegung der Kontakte der Modulkontaktleiste und ggf. der Aufsatzkontaktleiste beachten.

Im Falle der Funk-Netze kann die Schnittstelle für die Telekommunikationsübertragung in einem Antennenanschluß oder einer montierten Antenne bestehen. Diese können an der Basisplatine und/oder der Modulplatine vorgesehen sein. Für externe kabelgebundene Schnittstellen für die Telekommunikationsübertragung können vorzugsweise zwischen der Modulplatine und der Basisplatine interne Schnittstellen mit entsprechenden Basiskontaktleisten und Modulkontaktleisten eingerichtet sein, wobei dann auch insofern mit einer internen Norm bezüglich der Kontaktbelegung gearbeitet wird. Es kann dann auch zweckmäßig sein, für die insofern eingerichteten beiden internen Schnittstellen verschiedene Kontaktleisten vorzusehen.

Es versteht sich, daß sich die mit der Erfindung eingerichtete Normierung der internen Schnittstellen nicht nur auf die Belegung der Kontakte der Kontaktleisten bezieht, sondern auch auf deren mechanische Ausbildung und Ausrichtung.

Erfindungsgemäße Schaltungen werden bevorzugterweise für Fernwarten, Fernüberwachungen, Fernkonfigurierungen, POS, MDE, Zeiterfassung oder dezentrale Datenerfassung eingesetzt.

### Ausführungsbeispiele.

Im Folgenden wird die Erfindung anhand von lediglich Ausführungsbeispiele darstellenden Figuren näher erläutert. Es zeigen:
- Fig. 1:: eine Basisplatine in Aufsicht,
- Fig. 2:: eine Modulplatine in Seitenansicht,
- Fig. 3:: eine Modulplatine mit Aufsatzkontaktleiste in Seitenansicht,
- Fig. 4:: eine Seitenansicht einer Basisplatine mit zwei aufgesetzten verschiedenen Modulplatinen,
- Fig. 5:: Pinbelegung der Basiskontaktleiste der internen Schnittstelle für das Datensystem,
- Fig. 6:: Pinbelegung der Modulkontaktleiste einer Modem-Modulplatine,
- Fig. 7:: Pinbelegung der Modulkontaktleiste einer ISDN-Modulkontaktleiste und
- Fig. 8:: Pinbelegung der Modulkontaktleiste einer GSM-Modulkontaktleiste.

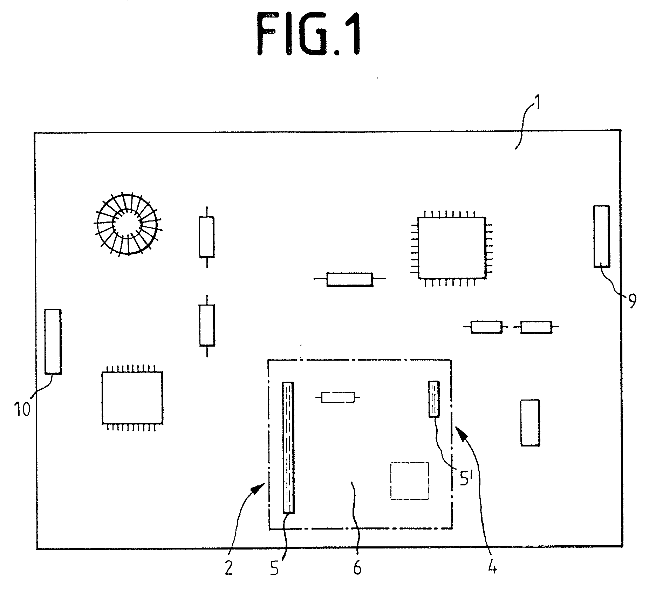

In der Fig. 1 erkennt man eine Basisplatine einer erfindungsgemäßen elektronischen Schaltung zur Datenfernübertragung. Sie weist eine interne Schnittstelle (2) für ein Datensystem auf. Weiterhin sind zwei Basiskontaktleisten (5, 5') sowie ein Einsteckfeld (6) eingerichtet. Schließlich sind zwei externe Schnittstellen (9, 10) für den Anschluß an einen Computer sowie an ein TK-Netz vorgesehen.

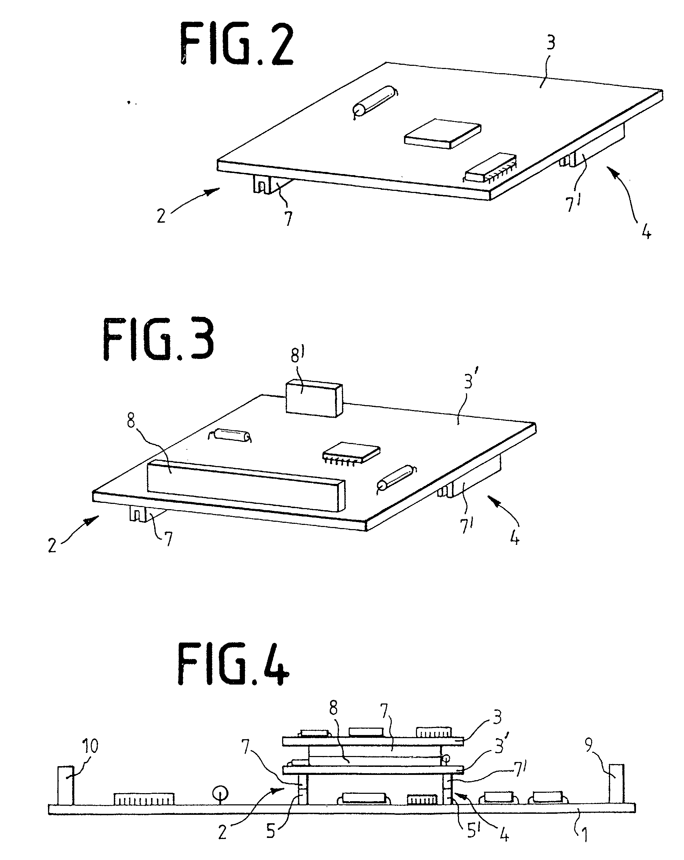

Die Figur 2 zeigt eine Modulplatine (3'), welche zur Umsetzung eines über die Schnittstelle (2) für das Datensystem eingespeisten Datenstroms in eine Signalfolge für die Telekommunikationsübertragung eingerichtet ist. Die Modulplatine (3') weist zwei zu den Basiskontaktleisten (5, 5') komplementäre Modulkontaktleisten (7, 7') auf.

Durch vergleichende Betrachtung der Figuren 1 und 2 erkennt man weiterhin, daß die Basisplatine (1) eine Schnittstelle (4) für eine Telekommunikationsübertragung aufweist, welche durch die Basiskontaktleiste (5') und die Modulkontaktleiste (7') gebildet ist.

Die Basiskontaktleisten (5, 5') und Modulkontaktleisten (7, 7') sind im einzelnen so ausgebildet, daß komplementäre Kontakte der Basiskontaktleisten (5, 5') und der Modulkontaktleisten (7, 7') lösbare elektrische Kontaktpaare sind. Die Anordnung der Basiskontaktleisten (5, 5') und der Modulkontaktleisten (7, 7') mit der Maßgabe getroffen, daß eine Kontaktierung durch Einsetzen der Modulplatine (3') in dem Einsteckfeld (6) erfolgt. Die Modulkontaktleisten (7, 7') liegen in den Bereichen zweier einander gegenüberliegenden Kanten der Modulplatine (3'), wozu auf die Fig. 2 verwiesen wird. Die Basiskontaktleisten (5, 5') sind entsprechend gegenüberliegend angeordnet.

In der Fig. 3 ist eine Modulplatine (3) dargestellt, die auf ihrer der die Modulkontaktleisten (7, 7') tragenden Hauptfläche gegenüberliegenden Hauptfläche zwei Aufsatzkontaktleisten (8, 8') zum Einstecken einer weiteren Modulplatine (3') aufweist.

In der Fig. 4 ist eine erfindungsgemäße elektronische Schaltung mit der Basisplatine (1) und mit einer ersten und einer zweiten Modulplatine (3, 3') dargestellt, welche wahlweise in die Basisplatine (1) einsteckbar sind. Die zweite Modulplatine (3') weist zwei eine Aufsatzkontaktleisten (8, 8') auf, welche in ihrer Ausbildung, Anordnung und Ausrichtung so eingerichtet sind, daß sich die erste Modulplatine (3) auf die in die Basisplatine (1) aufgesteckte zweite Modulplatine (3') aufstecken läßt. Die Modulkontaktleisten (7, 7') und die Aufsatzkontaktleisten (8, 8') der zweiten Modulplatine (3') sind bezüglich einer senkrecht zu den Hauptflächen der zweiten Modulplatine (3') stehenden Rotationsachse um 90° zueinander verdreht angeordnet.

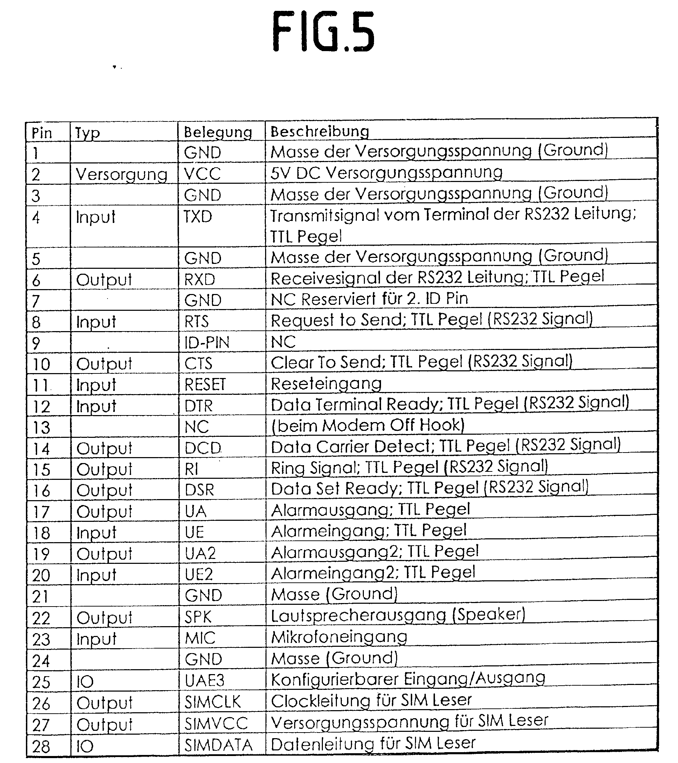

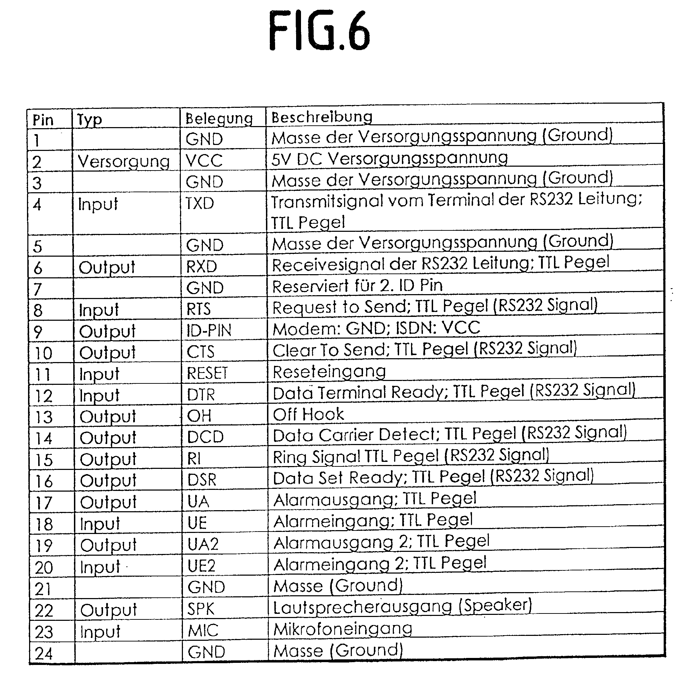

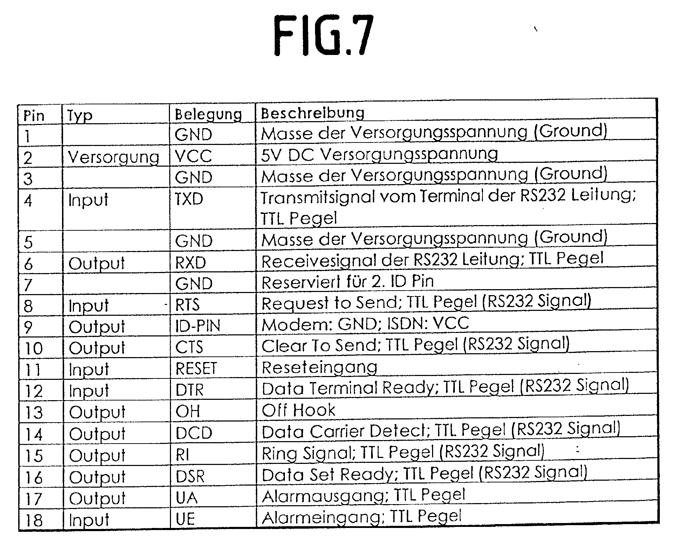

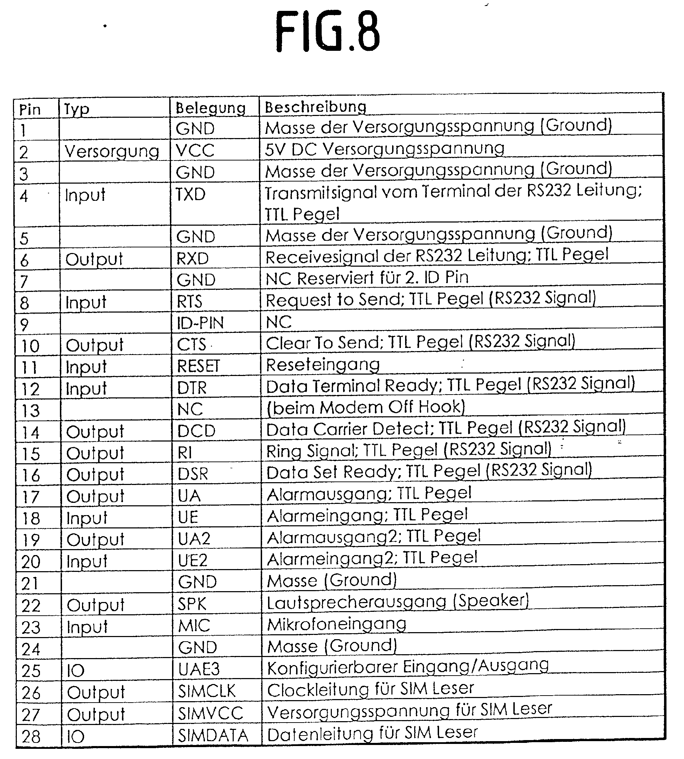

Die Figur 5 zeigt die Pinbelegung der Basiskontaktleiste (5), welche die interne Schnittstelle (2) für das Datensystem ist. Durch vergleichende Betrachtung einerseits der Fig. 5 und andererseits der Figuren 6 bis 8 erkennt man, daß für die Basiskontaktleiste (5) eine interne elektrische Belegungsnorm eingerichtet ist. Entsprechendes gilt natürlich auch bezüglich der mechanischen Anordnung und Ausbildung der Basiskontaktleisten (5, 5') und der Modulkontaktleisten (7, 7') sowie der Aufsatzkontaktleisten (8, 8'). Dabei kann hinsichtlich der mechanischen Ausbildung auch so gearbeitet werden, daß seitens der Modulkontaktleisten (7, 7') für nicht benötigte Daten- und/oder Steuerleitungen erst gar kein Kontakt vorgesehen ist. So weisen die Modulkontaktleisten (7) der Figuren 6 und 7 nur 24 Kontakte auf, während die Modulkontaktleiste der Figur 8 mit 28 Kontakten ausgestattet ist. Ein korrekte Positionierung und Sicherung gegen falsche Positionierung einer Modulkontaktleiste (7) mit weniger Kontakten auf bzw. in der Basiskontaktleiste (5) kann mit den fachüblichen Mittel erreicht werden. Im Falle mehrerer Basiskontaktleisten (5, 5') und Modulkontaktleisten (7, 7') kann dies bereits durch geeignete Ausrichtung der Kontaktleisten zueinander gewährleistet werden.

## Patentansprüche

1. Elektronische Schaltung zur Datenfernübertragung
mit einer Basisplatine (1), welche eine interne Schnittstelle (2) für ein Datensystem aufweist und
mit einer Modulplatine (3), welche zur Umsetzung eines über die interne Schnittstelle (2) für das Datensystem eingespeisten Datenstroms in eine Signalfolge für die Telekommunikationsübertragung eingerichtet ist,
wobei die Basisplatine (1) und/oder die Modulplatine (3) eine Schnittstelle (4) für eine Telekommunikationsübertragung aufweist,
wobei die Basisplatine (1) zumindest eine Basiskontaktleiste (5) sowie ein Einsteckfeld (6) aufweist,
wobei die Modulplatine (3) zumindest eine zur Basiskontaktleiste (5) komplementäre Modulkontaktleiste (7) aufweist,
wobei zueinander komplementäre Kontakte der Basiskontaktleiste (5) und der Modulkontaktleiste (7) lösbare elektrische Kontaktpaare sind und die interne Schnittstelle (2) bilden, und
wobei die Anordnung der Basiskontaktleiste (5) und der Modulkontaktleiste (7) mit der Maßgabe getroffen ist, daß eine Kontaktierung durch Einsetzen der Modulplatine (3) in dem Einsteckfeld (6) erfolgt.

2. Elektronische Schaltung nach Anspruch 1, wobei die Modulplatine (3) zumindest in den Bereichen zweier einander gegenüberliegenden Kanten jeweils eine Modulkontaktleiste (7) aufweist, wobei die Basisplatine (1) zumindest zwei hierzu komplementär im Bereich des Einsteckfeldes (6) ausgerichtete und angeordnete Basiskontaktleisten (5) aufweist.

3. Elektronische Schaltung nach Anspruch 1 oder 2, wobei die Modulplatine (3) auf ihrer der die Modulkontaktleiste (7) tragenden Hauptfläche gegenüberliegenden Hauptfläche zumindest eine Aufsatzkontaktleiste (8) zum Einstecken einer weiteren Modulplatine (3') aufweist.

4. Elektronische Schaltung nach Anspruch 3, mit einer ersten und einer zweiten Modulplatine (3, 3'), welche wahlweise in die Basisplatine (1) einsteckbar sind, wobei die zweite Modulplatine (3') zumindest eine Aufsatzkontaktleiste (8) aufweist, welche in ihrer Ausbildung, Anordnung und Ausrichtung so eingerichtet ist, daß sich die erste Modulplatine (3) auf die in die Basisplatine (1) aufgesteckte zweite Modulplatine (3') aufstecken läßt.

5. Elektronische Schaltung nach Anspruch 3 oder 4, wobei die Modulkontaktleiste (7) und die Aufsatzkontaktleiste (8) der zweiten Modulplatine (3') bezüglich einer senkrecht zu den Hauptflächen der zweiten Modulplatine (3') stehenden Rotationsachse zueinander verdreht, vorzugsweise um 90°, angeordnet sind.

6. Elektronische Schaltung nach einem der Ansprüche 3 bis 5, wobei die zweite Modulplatine (3') eine TCP/IP Schaltung trägt und wobei die erste Modulplatine (3) eine Schaltung aus der Gruppe "Modem, ISDN, GSM" trägt.

7. Modulplatinensatz für eine elektronische Schaltung nach einem der Ansprüche 1 bis 6, mit einer Mehrzahl von Modulplatinen (3, 3') mit unterschiedlichen Schaltungen, wobei die Belegung der elektrischen Kontakte der Modulkontaktleisten (7) verschiedener Modulplatinen (3, 3') kompatibel mit der Belegung der elektrischen Kontakte der Basiskontaktleisten (5) ist.

8. Modulplatinensatz nach Anspruch 7, wobei zumindest eine Modulplatine (3') zumindest eine Aufsatzkontaktleiste (8) aufweist, welche in ihrer Ausbildung und zumindest teilweisen Belegung der elektrischen Kontakte gleich der Basiskontaktleiste (5) ausgebildet ist, wobei vorzugsweise die Aufsatzkontaktleiste (8) und die Modulkontaktleiste (7) dieser Modulplatine (3') bezüglich einer senkrecht zu den Hauptflächen dieser Modulplatine (3') stehenden Rotationsachse zueinander verdreht, vorzugsweise um 90°, angeordnet sind.

9. Modulplatine (3') für eine elektronische Schaltung nach einem der Ansprüche 1 bis 6, mit zumindest einer Modulkontaktleiste (7) und zumindest einer Aufsatzkontaktleiste (8), wobei die Aufsatzkontaktleiste (8) in ihrer Ausbildung und zumindest teilweisen Belegung der elektrischen Kontakte gleich der Basiskontaktleiste (5) ausgebildet ist, wobei vorzugsweise die Aufsatzkontaktleiste (8) und die Modulkontaktleiste (7) bezüglich einer senkrecht zu den Hauptflächen der Modulplatine (3') stehenden Rotationsachse zueinander verdreht, vorzugsweise um 90°, angeordnet sind.
